# EUROPÄISCHE PATENTANMELDUNG

(11) **EP 0 872 889 A2**
(43) Veröffentlichungstag der Anmeldung: **21.10.1998**
(21) Anmeldenummer: 98106196.3
(22) Anmeldetag: 04.04.1998
(51) Int. Cl.: H01L 23/66, H01L 23/04

(54) **Gehäuse für elektronische Bauelemente**

(30) Priorität: 16.04.1997 DE 19715663
(71) Anmelder: Daimler-Benz Aerospace Aktiengesellschaft, 81663 München (DE)
(72) Erfinder: Rehme, Frank, 89077 Ulm (DE); Goebel, Uhland, 89250 Senden (DE)
(74) Vertreter: Fröhling, Werner Otto, Dr.

(57) **Zusammenfassung**

Die Erfindung betrifft eine neuartige Gehäuseform für monolithisch integrierte Millimeterwellen IC*'*s in der Radartechnologie. Eine Optimierung wird durch eine Materialkombination aus unterschiedlichen Werkstoffen erzielt, die in ihren Eigenschaften alle an das Gehäuse gestellten Erfordernisse berücksichtigen.

## Beschreibung

Die Erfindung betrifft Gehäuse für elektronische Bauelemente nach dem Oberbegriff des Patentanspruchs 1.

Die Anwendungsgebiete, bei denen monolithisch integrierte Millimeterwellen IC*'*s in der Radartechnologie eingesetzt werden, erfordern optimierte Lösungen in der Gehäusetechnik. Als Folge resultiert die Forderung zur Entwicklung neuartiger Gehäuseformen in Verbindung mit Werkstoffen, die eine gute thermische Leitfähigkeit aufweisen, gegen Umwelteinflüsse wie beispielsweise Feuchtigkeit schützen und zudem elektromagnetische Strahlung abschirmen. Herkömmliche Gehäuse für Millimeterwellenbauteile aus Kovar, Titan oder einer CuW-Legierung bestehen aus einer Grundplatte, auf der die elektronischen Bauteile befestigt sind und aus einem Deckel, der die Anordnung abschließt. Durchführungen am Gehäuse dienen zur Stromversorgung und als Zuleitung zur Sender/Empfänger-Antenne. Schon bei einfachen Gehäusegeometrien erfordert eine Herstellung aus den genannten Materialien eine Vielzahl von einzelnen kostenintensiven Bearbeitungsschritten. Eine Optimierung kann nur eine Materialkombination aus unterschiedlichen Werkstoffen darstellen, die in ihren Eigenschaften alle an das Gehäuse gestellten Erfordernisse berücksichtigen.

Der Erfindung liegt deshalb die Aufgabe zugrunde, ein Gehäuse anzugeben, das einer thermischen Wechselbelastung standhält und mit geringem Kostenaufwand herstellbar ist.

Die Erfindung wird durch die Merkmale des Patentanspruchs 1 wiedergegeben. Die weiteren Ansprüche enthalten vorteilhafte Aus- und Weiterbildungen der Erfindung.

Ein wesentlicher Vorteil der Erfindung besteht darin, daß eine Grundplatte, auf der die elektronischen Bauelemente befestigt sind, aus einem relativ starren, jedoch gut wärmeleitenden Material besteht. Die im Betrieb der elektronischen Bauelemente entstehende Wärme wird damit gezielt über die Grundplatte abgeleitet.
Ein weiterer wesentlicher Vorteil besteht dann, daß der Deckel aus einem flexiblen Kunststoffmaterial mittels Spritzgußtechnik hergestellt ist. Diese Technologie zeichnet sich dadurch aus, daß sehr komplexe Deckelgeometrien kostengünstig auf einfache Weise und in großen Stückzahlen hergestellt werden können. Ein balgförmiger Aufbau des Deckels gleicht das durch die Erwärmung bedingte unterschiedliche Ausdehnungsverhalten von Grundplatte und Deckel aus. Beispielsweise bei langgestreckter Form des Deckels ist es ausreichend, die unterschiedliche Ausdehnung von Grundplatte und Deckel in einer Dimension, nämlich entlang der Längsrichtung durchzuführen. Hingegen erfordert beispielsweise eine quadratische Form einen flächigen Ausgleich in zwei Dimensionen. Eine dünne Metallschicht auf der Innenseite oder Außenseite des Deckels schirmt die Umgebung gegen elektromagnetische Strahlung ab. Auf die Metallschicht kann in dem Fall verzichtet werden, wenn die abschirmende Wirkung durch Zugabe von Metallpartikeln oder anderen elektrisch leitenden Zuschlagstoffen in das Kunststoffmaterial des Deckels gewährleistet wird.
Zudem ist für eine im Gehäuse liegende Sender/Empfänger-Antenneneinheit eine Variante möglich, bei der die Strahlung durch den geschlossenen Gehäusedeckel hindurchtritt, indem ganz oder partiell im Bereich der Antenne auf eine Metallisierung verzichtet wird.

Im folgenden wird die Erfindung anhand von vorteilhaften Ausführungsbeispielen unter Bezugnahme auf schematische Zeichnungen in den folgenden Figuren näher erläutert. Es zeigen:
- Fig.1: Ansicht eines ersten Gehäuses mit parallel liegender Balgstruktur und schematisch einen Querschnitt entlang der Schnittlinie A-A*'*,
- Fig.2: Ansicht eines zweiten Gehäuses mit komplexerer Balgstruktur und schematisch einen Querschnitt entlang der Schnittlinie B-B*'*,
- Fig.3: Ansicht eines dritten Gehäuses mit radialsymmetrischer Balgstruktur und schematisch einen Querschnitt entlang der Schnittlinie C-C*'*.

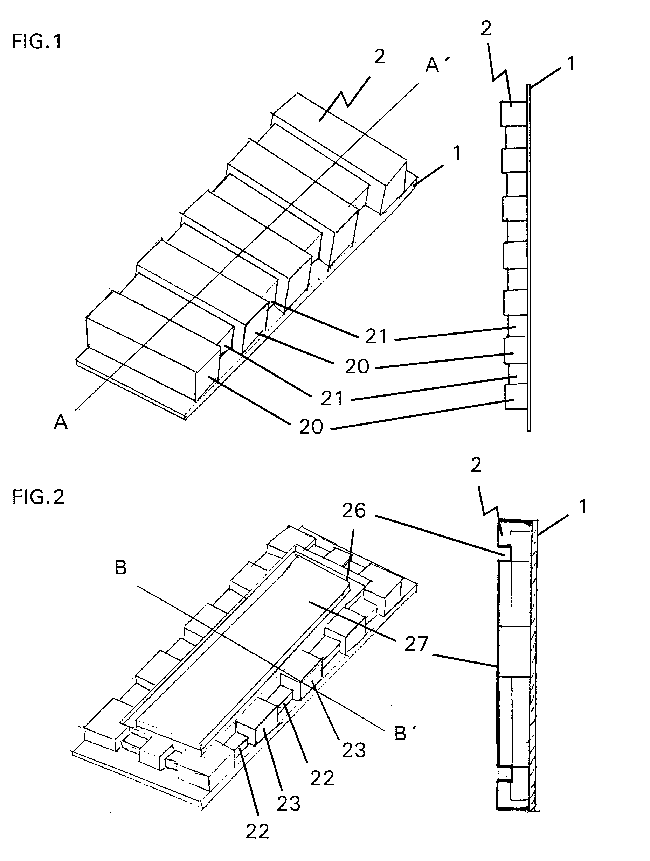

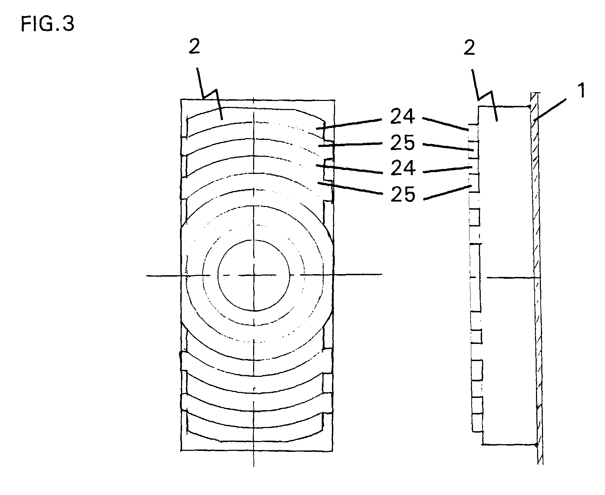

Im Ausführungsbeispiel gemäß Figur 1 ist ein erstes Gehäuse abgebildet, das aus einer ebenen Bodenplatte 1 aus Aluminiumnitrid (AlN) und einem Deckel 2 aus Kunststoff besteht. Bodenplatte 1 und Deckel 2 sind mit einem Kleber oder Lotmaterial miteinander verbunden. Zur Abschirmung elektromagnetischer Strahlung ist die Innenseite des Deckels mit einer dünnen Metallschicht versehen. Die unterschiedliche thermische Ausdehnung der Materialien führt dazu, daß der im Vergleich mit dem Keramiksubstrat flexible Deckel 2 die Längenänderung durch die Balgelemente 20 und 21 ausgleicht, ohne eine Verspannung aufzubauen, die zum Ablösen des Deckels von der Grundplatte 1 führt. In den Figuren sind nicht alle Balgelemente aus Gründen der Übersichtlichkeit mit den zugehörigen Bezugszeichen versehen.
Komplexere Deckelgeometrien sind in einer Variante gemaß Figur 2 dargestellt. Hier wurde die Deckelgeometrie nach den konstruktiven Vorgaben der auf der Grundplatte 1 montierten und zu häusenden elektrischen Bauteile gestaltet. Unter dem ebenen Mittelteil 27 befinden sind die elektrischen Bauelemente. Die durch eine Nut 26 vom Mittelteil 27 getrennte umlaufende balgförmige Außenberandung 22 und 23 gleicht die Längenänderung bezüglich der Grundplatte 1 aus.
In der dritten Variante gemaß Figur 3 ist durch eine radialsymmetrische Geometrie des Deckels 2 besonders punktförmigen, im Beispiel in der Mitte liegenden Wärmequellen Rechnung getragen. Die lokale Erwärmung im Zentrum wird durch die radialsymmetrisch angeordneten Balgelemente 24 und 25 ausgeglichen. Aus den Beispielen wird auch deutlich, daß durch das bei der Herstellung des Deckels 2 angewandte Spritzgußverfahren nahezujede Form erlaubt.

Die Erfindung ist nicht aufdie angegebenen Ausführungsbeispiele beschränkt, sondern ist sinngemäß aufweitere anwendbar. Dabei sind Deckelbeschichtungen aus Keramik denkbar und insbesondere kann die Grundplatte 1 aus einem Kunststoffmaterial aufgebaut sein.

Die Erfindung eignet sich nicht nur für die MMIC-Häusung (Gehäuse für Millimeterwellen-IC's), sondern auch für Elektronik- bzw. HF-Module. Die Erfindung kann vorteilhaft in der Radar- bzw. Kommunikationsgerätehäusungstechnologie eingesetzt werden.

## Patentansprüche

1. Gehäuse für elektronische Bauelemente, bestehend aus einer Grundplatte (1) und einem Deckel (2), dadurch gekennzeichnet,
daß die Geometrie des Deckels (2) eine Struktur aufweist, die unterschiedliches Ausdehnungsverhalten bezüglich der Grundplatte (1) auszugleichen vermag.

2. Gehäuse für elektronische Bauelemente nach Anspruch 1, dadurch gekennzeichnet, daß der Deckel (2) flexibler als die Grundplatte (1) ist.

3. Gehäuse für elektronische Bauelemente nach Anspruch 1 oder 2, dadurch gekennzeichnet, daß der Deckel (2) eine Struktur aufweist, die eine Ausdehnung in einer Dimension oder in zwei Dimensionen auszugleichen vermag.

4. Gehäuse für elektronische Bauelemente nach Anspruch 3, dadurch gekennzeichnet, daß der Deckel (2) balgförmig und mit einer zur Grundplatte (1) hin geöffneten Struktur ausgebildet ist.

5. Gehäuse für elektronische Bauelemente nach Anspruch 4, dadurch gekennzeichnet, daß der Deckel (2) eine Balgstruktur mit radialsymmetrisch oder oval oder parallel zueinander angeordneten Balgelementen (20, 21; 22, 23; 24, 25) aufweist.

6. Gehäuse für elektronische Bauelemente nach Anspruch 5, dadurch gekennzeichnet, daß die Balgelemente (20, 21; 22, 23; 24, 25) des Deckels (2) im Querschnitt sinusförmig oder rechteckig oder dreieckig ausgebildet sind.

7. Gehäuse für elektronische Bauelemente nach einem der vorangehenden Ansprüche, dadurch gekennzeichnet, daß der Deckel (2) aus einem thermoplastischen Kunststoff besteht.

8. Gehäuse für elektronische Bauelemente nach einem der vorangehenden Ansprüche, dadurch gekennzeichnet, daß der Deckel (2) aus einem Verbundwerkstoff aus thermoplastischem Kunststoff und Metall oder aus thermoplastischem Kunststoff und Keramik oder aus kunststoffbeschichtetem Metall oder aus metallbeschichtetem Kunststoff besteht.

9. Gehäuse für elektronische Bauelemente nach einem der vorangehenden Ansprüche, dadurch gekennzeichnet, daß der Deckel (2) aus einem ebenen Mittelteil (27) und, durch eine Nut (26) getrennt, einer umlaufenden balgförmigen Außenberandung (22, 23) besteht.

10. Gehäuse für elektronische Bauelemente nach einem der vorangehenden Ansprüche, dadurch gekennzeichnet, daß die Grundplatte (1) aus einem Metall oder einer Keramik besteht.
